# EUROPEAN PATENT APPLICATION

(11) **EP 4 513 750 A1**
(43) Date of publication of application: **26.02.2025**
(21) Application number: 24194942.9
(22) Date of filing: 16.08.2024
(51) Int. Cl.: H03F 1/02, H03F 3/195, H03F 3/21, H03F 3/24, H03F 3/72

(54) **TRANSMITTER, WIRELESS COMMUNICATION MODULE AND POWER AMPLIFICATION SYSTEM**

(30) Priority: 22.08.2023 KR 20230110161; 25.01.2024 KR 20240011873
(71) Applicant: Samsung Electronics Co., Ltd, Suwon-si, Gyeonggi-do 16677 (KR)
(72) Inventor: LEE, Wooseok, 16677 Suwon-si (KR); KANG, Minchul, 16677 Suwon-si (KR); YOO, Sangmin, 16677 Suwon-si (KR); BAE, Jeongyeol, 16677 Suwon-si (KR); LEE, Jongsoo, 16677 Suwon-si (KR)
(74) Representative: Marks & Clerk LLP

(57) **Abstract**

Disclosed is a transmitter. The transmitter includes a plurality of power amplifiers, each of the plurality of power amplifiers being configured to receive an RF input signal, a parallel power combiner configured to combine outputs of the plurality of power amplifiers to generate an RF output signal, a supply voltage switch configured to provide one supply voltage to the plurality of power amplifiers, the one supply voltage being selected from among a plurality of supply voltages of different voltage levels, and a controller configured to control an output power of the RF output signal by selecting the one supply voltage from among the plurality of supply voltages, and controlling whether to activate each of the plurality of power amplifiers.

## Description

### BACKGROUND

Embodiments of the present disclosure described herein relate to a transmitter, a wireless communication module, and a power amplification system.

In a wireless communication system, a power amplifier may serve to amplify the power of a transmitter signal such that electromagnetic waves reach a desired location through an antenna.

During wireless communication, the transmitter may use various output powers depending on the situation. To this end, a conventional transmitter provides a separate output path for each output power. In this case, because separate power amplifiers and passive elements are used for each output path, the area of the transmitter or power amplifier within a communication chip increases and the cost increases.

### SUMMARY

Embodiments of the present disclosure provide a transmitter, a wireless communication module, and a power amplification system capable of providing a plurality of output powers through a single output path.

According to embodiments, a transmitter includes a plurality of power amplifiers, each of the plurality of power amplifiers being configured to receive an RF input signal, a parallel power combiner configured to combine outputs of the plurality of power amplifiers to generate an RF output signal, a supply voltage switch configured to provide one supply voltage to the plurality of power amplifiers, the one supply voltage being selected from among a plurality of supply voltages of different voltage levels, and a controller configured to control an output power of the RF output signal by selecting the one supply voltage from among the plurality of supply voltages, and controlling whether to activate each of the plurality of power amplifiers.

According to embodiments, the parallel power combiner may include a plurality of primary windings respectively connected to output terminals of the plurality of power amplifiers, and a single secondary winding inductively coupled with the plurality of primary windings.

According to embodiments, the single secondary winding may include one end connected to a ground and an opposite end configured to output the RF output signal.

According to embodiments, each of the plurality of primary windings may include a center tap port, and the one supply voltage may be provided to each of the plurality of power amplifiers through the center tap port of each of the plurality of primary windings.

According to embodiments, the supply voltage switch may include a plurality of switches respectively corresponding to the plurality of supply voltages, the parallel power combiner may include a plurality of primary windings respectively connected to output terminals of the plurality of power amplifiers, and each of the plurality of switches may have a first end and a second end, the first end being connected to a corresponding supply voltage among the plurality of supply voltages, and the second end being connected to center tap ports of the plurality of primary windings.

According to embodiments, the controller may be configured to select the one supply voltage by providing a control signal to the supply voltage switch, the control signal causing the supply voltage switch to turn on a first switch corresponding to the one supply voltage among the plurality of switches, and turn off a second switch corresponding to a supply voltage different from the one supply voltage, the second switch being among the plurality of switches.

According to embodiments, each of the plurality of power amplifiers may be configured to output an amplified signal corresponding to the RF input signal in an activated state, and not output the amplified signal corresponding to the RF input signal in a deactivated state.

According to embodiments, each respective power amplifier among the plurality of power amplifiers may include a corresponding activation control port for determining activation or deactivation of the respective power amplifier, and the controller may be configured to control whether to activate each respective power amplifier among the plurality of power amplifiers by providing a corresponding control signal to the corresponding activation control port.

According to embodiments, each of the plurality of power amplifiers may be a differential amplifier.

According to embodiments, each of the plurality of power amplifiers may have a common power gain.

According to embodiments, the plurality of power amplifiers may include a first power amplifier and a second power amplifier having different power gains.

According to embodiments, the RF output signal may have an output power level corresponding to a power mode selected from among a plurality of power modes, each of the plurality of power modes having a corresponding output power level, and the controller may be configured to select one power mode from among the plurality of power modes by selecting one supply voltage from among the plurality of supply voltages, and controlling whether to activate each of the plurality of power amplifiers.

According to embodiments, the output power of the RF output signal may increase as a higher supply voltage is selected as the one supply voltage from among the plurality of supply voltages.

According to embodiments, the output power of the RF output signal may increase as a number of activated power amplifiers among the plurality of power amplifiers increases.

According to embodiments, an impedance viewed from an output terminal of an activated power amplifier toward the parallel power combiner may increase as a number of deactivated power amplifiers among the plurality of power amplifiers increases, the activated power amplifier being among the plurality of power amplifiers.

According to embodiments, a wireless communication module includes a plurality of power amplifiers, each of the plurality of power amplifiers being configured to receive an RF input signal, a plurality of primary windings respectively connected to output terminals of the plurality of power amplifiers, a single secondary winding inductively coupled with the plurality of primary windings, the single secondary winding being configured to generate an RF output signal, a supply voltage switch configured to provide one supply voltage to the plurality of power amplifiers, the one supply voltage being selected from among a plurality of supply voltages of different voltage levels, and a controller configured to select the one supply voltage from among the plurality of supply voltages, and control whether to activate each of the plurality of power amplifiers.

According to embodiments, the wireless communication module may be one of a Bluetooth communication module, a Wi-Fi communication module, or a mobile communication module.

According to embodiments, a power amplification system includes a plurality of power amplifiers, each of the plurality of power amplifiers being configured to receive an RF input signal, a parallel power combiner configured to generate an RF output signal based on an output of at least one among the plurality of power amplifiers, and a supply voltage switch configured to provide one supply voltage to the plurality of power amplifiers, the one supply voltage being selected from among a plurality of supply voltages of different voltage levels.

According to embodiments, the parallel power combiner may include a plurality of primary windings respectively connected to output terminals of the plurality of power amplifiers; and a single secondary winding inductively coupled with the plurality of primary windings.

According to embodiments, the supply voltage switch may include a plurality of switches respectively corresponding to the plurality of supply voltages, the parallel power combiner may include a plurality of primary windings respectively connected to output terminals of the plurality of power amplifiers, and each of the plurality of switches may have a first end and a second end, the first end being connected to a corresponding supply voltage among the plurality of supply voltages, and the second end being connected to center tap ports of the plurality of primary windings.

According to embodiments of the present disclosure described above, it is possible to provide a transmitter, a wireless communication module, and a power amplification system capable of providing a plurality of output powers through a single output path.

At least some of the above and other features of the invention are set out in the claims.

### BRIEF DESCRIPTION OF THE FIGURES

The above and other features of the present disclosure will become apparent by describing in detail embodiments thereof with reference to the accompanying drawings.
FIG. 1 is a block diagram illustrating the configuration of a transmitter according to embodiments of the present disclosure;
FIG. 2 is a block diagram illustrating an example of implementation of the transmitter of FIG. 1;
FIG. 3 is a diagram illustrating power efficiency according to the operation of a transmitter according to embodiments of the present disclosure;
FIG. 4A is diagram illustrating an operation mode of a transmitter according to embodiments of the present disclosure;
FIG. 4B is diagram illustrating an operation mode of a transmitter according to embodiments of the present disclosure;
FIG. 4C is diagram illustrating an operation mode of a transmitter according to embodiments of the present disclosure;
FIG. 4D is diagram illustrating an operation mode of a transmitter according to embodiments of the present disclosure;
FIG. 5 is a diagram illustrating power efficiency according to the operation modes of FIGS. 4A and 4B;
FIG. 6A is a diagram illustrating the operation mode of a transmitter according to embodiments of the present disclosure;
FIG. 6B is a diagram illustrating the operation mode of a transmitter according to embodiments of the present disclosure;
FIG. 6C is a diagram illustrating the operation mode of a transmitter according to embodiments of the present disclosure;
FIG. 6D is a diagram illustrating the operation mode of a transmitter according to embodiments of the present disclosure;
FIG. 6E is a diagram illustrating the operation mode of a transmitter according to embodiments of the present disclosure;
FIG. 7 is a diagram illustrating power efficiency according to the operation modes of FIGS. 6A to 6E;
FIG. 8 is a block diagram illustrating the configuration of a wireless communication module according to embodiments of the present disclosure; and
FIG. 9 is a flow chart illustrating an operating method of a transmitter according to embodiments of the present disclosure.

### DETAILED DESCRIPTION

Hereinafter, embodiments of the present disclosure will be described in detail with reference to the accompanying drawings, so that those skilled in the art may easily carry out the present disclosure.

Expressions such as "first," or "second," and the like, may express their elements regardless of their priority or importance and may be used to simply distinguish one element from another element but is not limited to the priority or the importance of the elements.

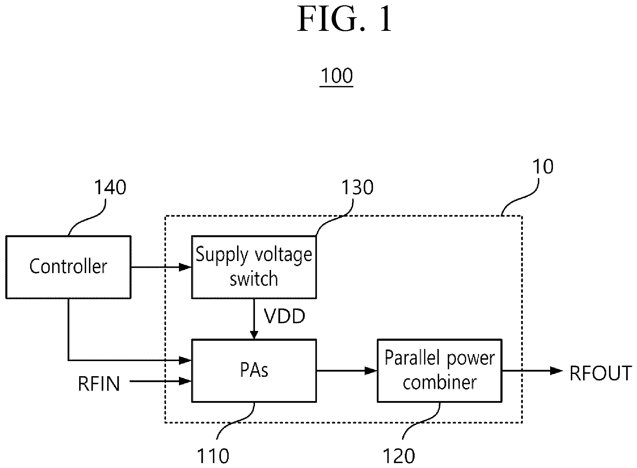

FIG. 1 is a block diagram illustrating the configuration of a transmitter according to embodiments of the present disclosure. Referring to FIG. 1, a transmitter 100 may include a plurality of power amplifiers 110, a parallel power combiner 120, a supply voltage switch 130, and/or a controller 140. According to embodiments, the transmitter 100 may be included in a user equipment (UE). The UE may be fixed or mobile and may refer to any device that may communicate with a base station, and/or another UE, to transmit and receive data and/or control information. For example, the UE may be referred to as a terminal, a terminal equipment, a mobile station (MS), a mobile terminal (MT), a user terminal (UT), a subscriber station (SS), a wireless device, a handheld device, or the like. According to embodiments, the transmitter 100 may be included in a base station. The base station may generally refer to a fixed station that communicates with UEs and/or other base stations, and may exchange data and control information by communicating with user equipment and/or other base stations. For example, the base station may also be referred to as a Node B, an evolved-Node B (eNB), a next generation Node B (gNB), a sector, a site, a base transceiver system (BTS), an access point (AP), a relay node, a remote radio head (RRH), a radio unit (RU), a small cell, or the like. In the present specification, a base station or a cell may be interpreted in a comprehensive sense to indicate some area or function covered by a base station controller (BSC) in CDMA, a Node-B in WCDMA, an eNB in LTE, a gNB or sector (site) in 5G, and the like, and may cover all the various coverage areas such as megacell, macrocell, microcell, picocell, femtocell and relay node, RRH, RU, and small cell communication range.

Each of the plurality of power amplifiers 110 may receive a radio frequency (RF) input signal RFIN and may amplify the power of the RF input signal RFIN based on a supply voltage VDD provided from the supply voltage switch 130.

In this case, each of the plurality of power amplifiers 110 may be independently activated or deactivated under control of the controller 140. Each of the plurality of power amplifiers 110 may output an amplified signal corresponding to the RF input signal RFIN in an activated state and may not output the amplified signal corresponding to the RF input signal RFIN in a deactivated state.

The parallel power combiner 120 may generate an RF output signal RFOUT by parallel combining the outputs of the plurality of power amplifiers 110. To this end, the parallel power combiner 120 may include a plurality of primary windings respectively corresponding to the plurality of power amplifiers 110 and a single secondary winding inductively coupled with the plurality of primary windings.

The supply voltage switch 130 may provide one supply voltage selected from among a plurality of supply voltages having different levels to the plurality of power amplifiers 110. To this end, the supply voltage switch 130 may include a plurality of switches that correspond to a plurality of supply voltages, respectively.

The controller 140 may control the supply voltage switch 130 to select one supply voltage VDD from among a plurality of supply voltages. Each of the plurality of power amplifiers 110 may output an output signal with higher power as the supply voltage VDD provided from the supply voltage switch 130 increases. Accordingly, the output power of the RF output signal RFOUT may increase as a higher supply voltage is selected from among the plurality of supply voltages. As described above, the controller 140 may control the output power of the RF output signal by selecting the supply voltage.

In addition, the controller 140 may control whether to activate each of the plurality of power amplifiers. In the deactivated state, each of the plurality of power amplifiers 110 does not output an amplified signal corresponding to the RF input signal RFIN even when a supply voltage is provided. Accordingly, the output power of the RF output signal RFOUT may increase as the number of activated power amplifiers among the plurality of power amplifiers 110 increases. Thus, the controller 140 may control the output power of the RF output signal by controlling whether to activate each of the plurality of power amplifiers 110.

Therefore, the controller 140 may select one supply voltage from among the plurality of supply voltages and control whether to activate each of the plurality of power amplifiers 110, thereby controlling the output power of the RF output signal RFOUT.

According to embodiments, the RF output signal RFOUT may have an output power level corresponding to one power mode selected from a plurality of power modes each having a corresponding output power level. In this case, the controller 140 may select one from the plurality of power modes by selecting one from the plurality of supply voltages and controlling whether to activate each of the plurality of power amplifiers. According to embodiments, the controller 140 may select one of the power modes based on a desired output power (e.g., signal strength) of a communication signal to be transmitted. For example, the controller 140 may select one of the power modes based on one or more characteristics of a communication channel, a distance to a recipient of the communication signal, a signal strength of a signal received from the recipient, etc.

According to embodiments, the plurality of power amplifiers 110, the parallel power combiner 120, and the supply voltage switch 130 may constitute a power amplification system 10. As described above, the power amplification system 10 may generate the RF output signal RFOUT by amplifying the RF input signal RFIN under control of the controller 140.

According to embodiments of the present disclosure described above, the transmitter 100 or the power amplification system 10 may provide a plurality of output powers through a single output path. In addition, because the parallel power combiner 120 including the single secondary winding is used, area and cost may be reduced compared to conventional technology. In addition, because output powers are implemented by adjusting the supply voltage and whether to activate the power amplifier, optimized (or reduced) power consumption may be achieved.

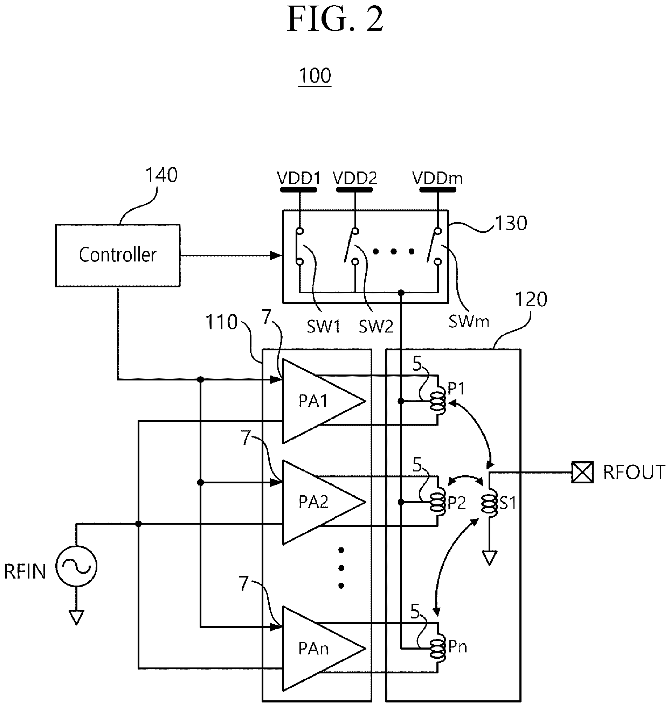

FIG. 2 is a block diagram illustrating an example of implementation of the transmitter of FIG. 1. Referring to FIG. 2, the transmitter 100 may include the plurality of power amplifiers 110, the parallel power combiner 120, the supply voltage switch 130, and/or the controller 140.

The plurality of power amplifiers 110 may include n power amplifiers (hereinafter, referred to as PA1 to PAn). Each of the PA1 to PAn 110 may receive the same RF input signal RFIN (or a similar RF input signal RFIN). In this case, the RF input signal RFIN may be received, for example, from a transmission circuit (not shown) for frequency up-conversion, but embodiments are not limited thereto.

According to embodiments, each of the PA1 to PAn 110 may be a differential amplifier. In the drawing, the RF input signal RFIN is shown to be applied to each of the PA1 to PAn through one line, but this is only for convenience of illustration, and the RF input signal RFIN may be a differential signal.

The parallel power combiner 120 may generate the RF output signal RFOUT by parallel combining the outputs of the PA1 to PAn 110. To this end, the parallel power combiner 120 may include a plurality of primary windings P1 to Pn respectively connected to output terminals of the PA1 to PAn 110, and a single secondary winding S1 inductively coupled with the plurality of primary windings P1 to Pn. According to embodiments, the PA1 to PAn 110 may include a number of power amplifiers 110 equal to a number of the plurality of primary windings P1 to Pn. In this case, the single secondary winding S1 may include one end connected to the ground and an opposite end for outputting the RF output signal RFOUT.

Each of the plurality of primary windings P1 to Pn may include a center tap port 5. The supply voltage provided from the supply voltage switch 130 may be provided to each of the plurality of power amplifiers 110 through the center tap port 5 of each of the plurality of primary windings P1 to Pn. In this case, the supply voltage may correspond to the power supply voltage (or driving voltage) of the power amplifiers 110 and may be a different voltage from the bias voltage related to the operating point of the power amplifiers 110.

According to embodiments, when a differential output signal is generated in each primary winding P1 to Pn by the corresponding power amplifiers PA1 to PAn, an alternating current (AC) virtual ground is present in each center tap port 5. In addition, according to embodiments, the center tap port 5 may be positioned at the center or symmetrical point of each primary winding P1 to Pn. However, embodiments are not limited to the above, and the position of the center tap port 5 may vary from the center or symmetrical point depending on the amplitude of the differential output signal generated by the power amplifiers PA1 to PAn.

The supply voltage switch 130 may provide one supply voltage (e.g., only one supply voltage) selected from among a plurality of supply voltages VDD1 to VDDm of different levels to the plurality of power amplifiers 110. To this end, the supply voltage switch 130 may include a plurality of switches SW1 to SWm that correspond to a plurality of supply voltages, respectively. According to embodiments, the plurality of switches SW1 to SWm may include a number of switches equal to a number of the plurality of supply voltages. Each of the plurality of switches SW1 to SWm may have one terminal (e.g., a first end) connected to the corresponding supply voltage VDD1 to VDDm and another terminal (e.g., a second end) connected to the center tap ports 5 of the plurality of primary windings P1 to Pn.

The controller 140 may provide a control signal for turning on the switch SW1 corresponding to a specific supply voltage (e.g., VDD1) among the plurality of switches SW1 to SWm and for turning off the remaining switches (e.g., switches that do not correspond to the specific supply voltage) to the supply voltage switch 130, thereby selecting a specific supply voltage (e.g., VDD1) to be provided to the plurality of power amplifiers 110. According to embodiments, the control signal(s) provided to the plurality of switches SW1 to SWm may indicate which among the plurality of switches SW1 to SWm should turn on and/or which should turn off.

Each of the plurality of power amplifiers 110 may amplify the power of the RF input signal RFIN based on the supply voltage provided from the supply voltage switch 130. For example, each of the plurality of power amplifiers 110 may output an output signal with higher power as the supply voltage provided from the supply voltage switch 130 increases. The outputs of the plurality of power amplifiers 110 may be respectively coupled to the secondary winding S1 through the corresponding primary windings P1 to Pn to be parallel combined with each other, thereby generating the RF output signal RFOUT. According to embodiments, the parallel power combiner 120 may include only one secondary winding S1.

Each of the plurality of power amplifiers 110 may include an activation control port 7 for determining activation or deactivation of the corresponding power amplifier. For example, each of the plurality of power amplifiers 110 may include a switch that activates/deactivates the corresponding power amplifier according to on/off operation. In this case, the switch may be turned on/off according to a control signal applied to the activation control port 7. Accordingly, each of the plurality of power amplifiers 110 may be activated or deactivated according to the control signal applied to the activation control port 7. According to embodiments, the control signal(s) provided to the plurality of power amplifiers 110 may indicate which among the plurality of power amplifiers 110 should activate and/or which should deactivate.

The controller 140 may provide a control signal for determining whether to activate the corresponding power amplifier to each activation control port 7 to control whether to activate each of the plurality of power amplifiers 110.

Each of the plurality of power amplifiers 110 may output an output signal corresponding to the RF input signal RFIN only in an activated state. Therefore, compared to the case where all of the plurality of power amplifiers 110 are activated, the output power of the RF output signal RFOUT generated from the secondary winding S1 may be lowered by the number of deactivated power amplifiers.

In a typical multi-power mode power amplifier, a series-connected power combiner is used in an output terminal. In this case, because there are plural secondary windings, the area of a chip may be relatively large. According to embodiments of the present disclosure, because the parallel power combiner 120 including the single secondary winding S1 is used in the output terminal, the area and cost may be minimized (or reduced) compared to general technology.

In addition, according to embodiments of the present disclosure, various supply voltages may be used using the supply voltage switch 130. Therefore, for example, in a higher output operation mode, the output power of the RF output signal RFOUT may be increased by using a higher supply voltage, and in a lower output operation mode, power consumption may be reduced by using a lower supply voltage. In addition, according to embodiments of the present disclosure, activation and deactivation of each of the plurality of power amplifiers 110 may be controlled. Accordingly, power consumption optimized (or reduced) for various output powers may be achieved.

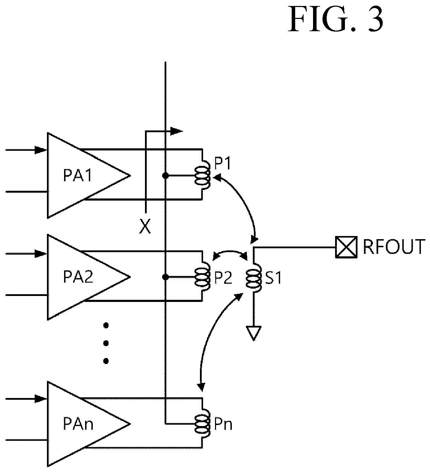

FIG. 3 is a diagram illustrating power efficiency according to the operation of a transmitter according to embodiments of the present disclosure. FIG. 3 illustrates a part of the transmitter 100 of FIG. 2.

According to embodiments of the present disclosure, the impedance viewed from the output terminal of the activated power amplifier toward the parallel power combiner 120 may increase as the number of deactivated power amplifiers among the plurality of power amplifiers 110 increases.

Referring to FIG. 3, for example, assuming a situation where PA1 is activated and at least some of the remaining power amplifiers are deactivated, the impedance X viewed from the output terminal of PA1 toward the parallel power combiner 120 may increase as the number of deactivated power amplifiers among PA2 to PAn increases.

Therefore, as the number of deactivated power amplifiers among PA2 to PAn increases, the output power of the RF output signal RFOUT decreases, but the impedance X viewed from the output of PA1 increases, so that the power efficiency of the output signal output from PA1 may be improved.

That is, according to embodiments of the present disclosure, the transmitter 100 may include the parallel power combiner 120 at the output terminal. The parallel power combiner 120 may have a structure that includes the plurality of primary windings P1 to Pn connected to the output terminals of the plurality of power amplifiers 110, respectively, and the single secondary winding S1 inductively coupled with the plurality of primary windings P1 to Pn. Accordingly, when some of the plurality of power amplifiers 110 are deactivated and operate at a back-off level, the power efficiency of the activated power amplifiers may be improved.

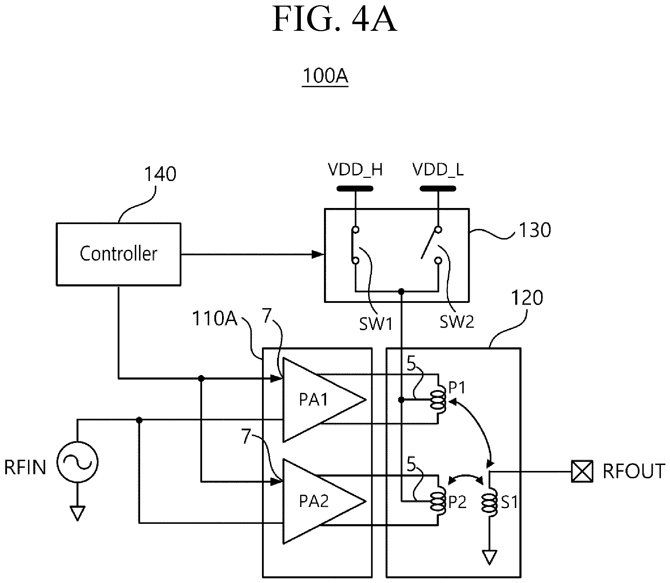

FIGS. 4A to 4D are diagrams illustrating operation modes of a transmitter according to embodiments of the present disclosure.

Referring to FIGS. 4A to 4D, a transmitter 100A may include a plurality of power amplifiers 110A, the parallel power combiner 120, the supply voltage switch 130, and/or the controller 140.

The plurality of power amplifiers 110A may include a first power amplifier PA1 and a second power amplifier PA2. The first power amplifier PA1 and the second power amplifier PA2 may receive the same RF input signal RFIN (or similar RF input signals RFIN), respectively.

In this case, according to embodiments, the first power amplifier PA1 and the second power amplifier PA2 may have the same (e.g., a common) power gain (or similar power gains). The power gain of a power amplifier may vary depending on the size of a transistor included in the power amplifier. For example, a power amplifier including a relatively large-sized transistor may have a higher power gain than a power amplifier including a relatively small-sized transistor. Accordingly, the first power amplifier PA1 and the second power amplifier PA2 of the transmitter 100A may include transistors of the same size (or similar sizes).

The parallel power combiner 120 includes a primary winding P1 connected to the output terminal of the first power amplifier PA1, a primary winding P2 connected to the output terminal of the second power amplifier PA2, and the single secondary winding S1 inductively coupled with the primary windings P1 and P2.

The supply voltage switch 130 may include a first switch SW1 having one terminal connected to a first supply voltage VDD_H and another terminal connected to the center tap ports 5 of the primary windings P1 and P2, respectively, and a second switch SW2 having one terminal connected to a second supply voltage VDD_L and another terminal connected to the center tap ports 5 of the primary windings P1 and P2, respectively. In this case, the first supply voltage VDD_H may be higher than the second supply voltage VDD_L.

The controller 140 may select one supply voltage from among the plurality of supply voltages VDD_H and VDD L, and control whether to activate each of the plurality of power amplifiers PA1 and PA2, thereby controlling the output power of the RF output signal RFOUT.

According to embodiments, the RF output signal RFOUT may have an output power level corresponding to a selected power mode from among a plurality of power modes, each having a corresponding output power level. FIGS. 4A to 4D illustrate four power modes corresponding to four output power levels of the RF output signal RFOUT of the transmitter 100A. The controller 140 may select one supply voltage from among the plurality of supply voltages VDD_H and VDD_L, and control whether to activate each of the plurality of power amplifiers PA1 and PA2, thereby selecting one from the plurality of power modes.

FIG. 4A illustrates a maximum (or highest) mode in which the RF output signal RFOUT of the transmitter 100A has the highest output power level. Referring to FIG. 4A, the controller 140 may select the maximum (or highest) mode by selecting the first supply voltage VDD_H and activating all of the plurality of power amplifiers PA1 and PA2. To this end, the controller 140 may provide the supply voltage switch 130 with a control signal for turning on the first switch SW1 and turning off the second switch SW2. Accordingly, the first supply voltage VDD_H may be selected. In addition, the controller 140 may provide a control signal for activating the first and second power amplifiers PA1 and PA2 to the activation control ports 7 of the first and second power amplifiers PA1 and PA2, respectively. Accordingly, both the first and second power amplifiers PA1 and PA2 may be activated.

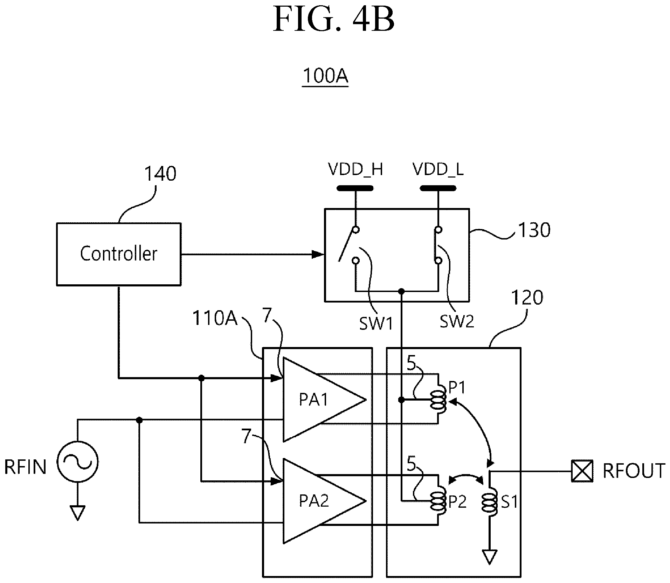

FIG. 4B illustrates a medium mode in which the RF output signal RFOUT of the transmitter 100A has the second highest output power level. Referring to FIG. 4B, the controller 140 may select the second supply voltage VDD_L and activate all of the plurality of power amplifiers PA1 and PA2, thereby selecting the medium mode. To this end, the controller 140 may provide a control signal for turning off the first switch SW1 and turning on the second switch SW2 to the supply voltage switch 130. Accordingly, the second supply voltage VDD_L may be selected. In addition, the controller 140 may provide a control signal for activating the first and second power amplifiers PA1 and PA2 to the activation control ports 7 of the first and second power amplifiers PA1 and PA2, respectively. Accordingly, both the first and second power amplifiers PA1 and PA2 may be activated.

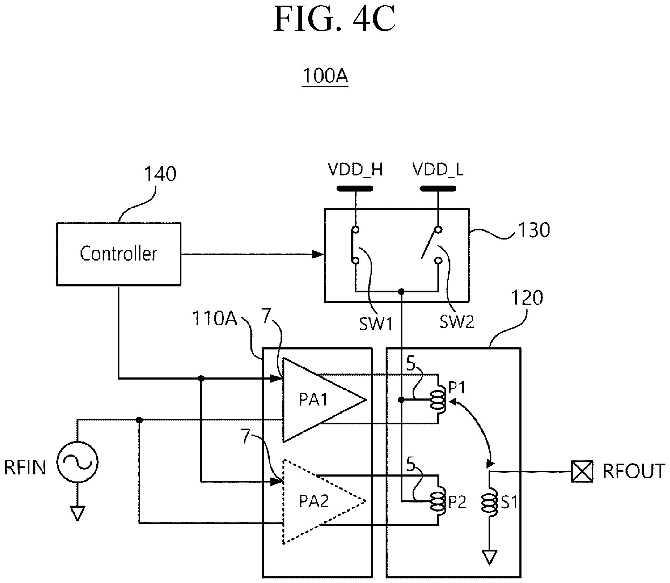

FIG. 4C illustrates a lower mode in which the RF output signal RFOUT of the transmitter 100A has the third highest output power level. Referring to FIG. 4C, the controller 140 may select the first supply voltage VDD_H, activate the first power amplifier PA1, and deactivate the second power amplifier PA2, thereby selecting the lower mode. To this end, the controller 140 may provide a control signal for turning on the first switch SW1 and turning off the second switch SW2 to the supply voltage switch 130. Accordingly, the first supply voltage VDD_H may be selected. In addition, the controller 140 may provide a control signal for activating the first power amplifier PA1 to the activation control port 7 of the first power amplifier PA1, and may provide a control signal for deactivating the second power amplifier PA2 to the activation control port 7 of the second power amplifier PA2. Accordingly, the first power amplifier PA1 may be activated and the second power amplifier PA2 may be deactivated.

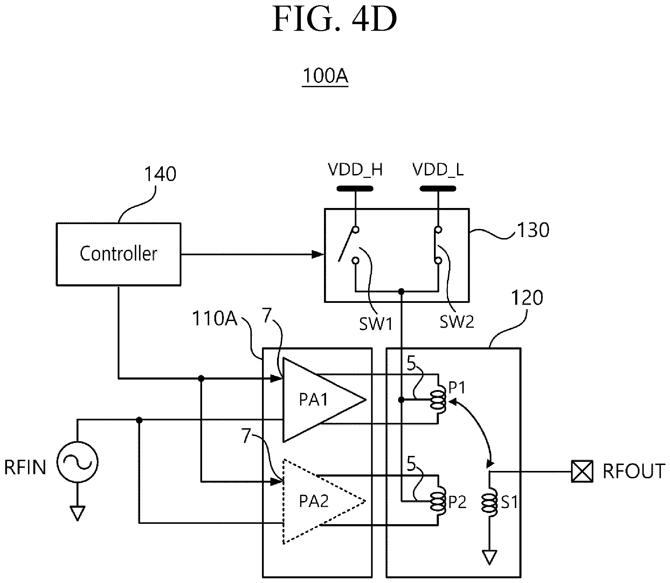

FIG. 4D illustrates an ultra-low mode in which the RF output signal RFOUT of the transmitter 100A has the lowest output power level. Referring to FIG. 4D, the controller 140 may select the second supply voltage VDD_L, activate the first power amplifier PA1, and deactivate the second power amplifier PA2, thereby selecting the ultra-low mode. To this end, the controller 140 may provide a control signal for turning off the first switch SW1 and turning on the second switch SW2 to the supply voltage switch 130. Accordingly, the second supply voltage VDD_L may be selected. In addition, the controller 140 may provide a control signal for activating the first power amplifier PA1 to the activation control port 7 of the first power amplifier PA1, and provide a control signal for deactivating the second power amplifier PA2 to the activation control port 7 of the second power amplifier PA2. Accordingly, the first power amplifier PA1 may be activated and the second power amplifier PA2 may be deactivated.

Because the first power amplifier PA1 and the second power amplifier PA2 have the same power gain (or similar power gains), in the examples of FIGS. 4C and 4D, even though the first power amplifier PA1 is turned off and the second power amplifier PA2 is turned on, the transmitter 100A may operate in the lower mode or ultra-low mode.

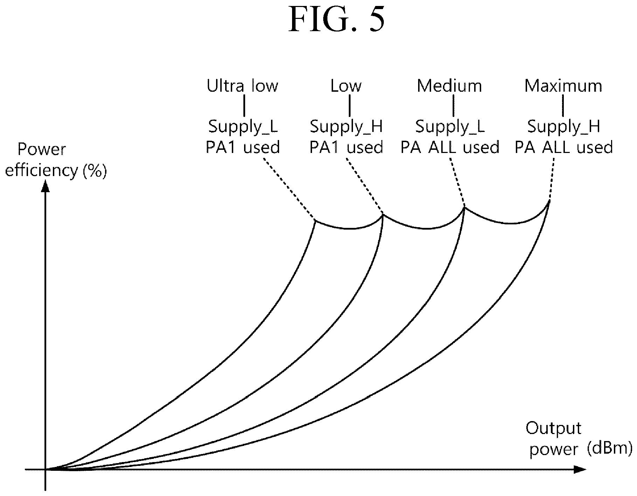

FIG. 5 is a diagram illustrating power efficiency according to the operation modes of FIGS. 4A and 4B. Referring to FIG. 5, it may be confirmed that in all four modes, higher power efficiency is maintained at a level similar to the power efficiency at maximum (or highest) output.

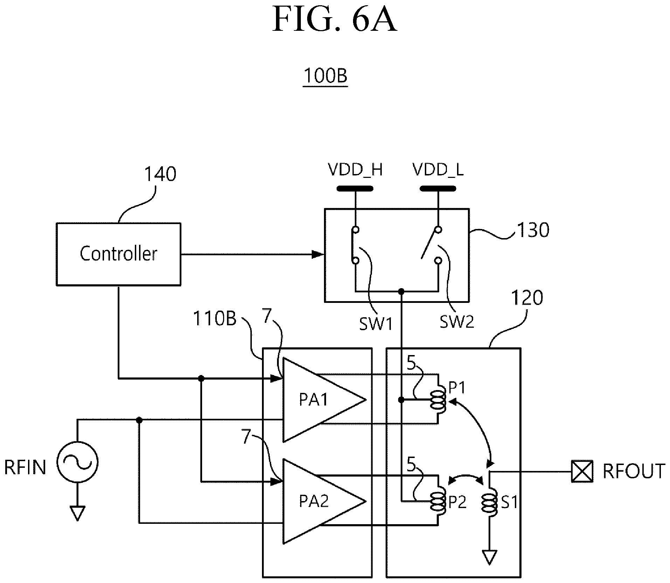

FIGS. 6A to 6E are diagrams illustrating the operation mode of a transmitter according to embodiments of the present disclosure.

Referring to FIGS. 6A to 6E, a transmitter 100B may include a plurality of power amplifiers 110B, the parallel power combiner 120, the supply voltage switch 130, and/or the controller 140.

The plurality of power amplifiers 110B may include the first power amplifier PA1 and the second power amplifier PA2. The first power amplifier PA1 and the second power amplifier PA2 may receive the same RF input signal RFIN (or similar RF input signals RFIN).

In this case, according to embodiments, the first power amplifier PA1 and the second power amplifier PA2 may have different power gains. For example, the first power amplifier PA1 may have a higher power gain than the second power amplifier PA2. In this case, the transistor included in the first power amplifier PA1 may have a larger size than the transistor included in the second power amplifier PA2.

The parallel power combiner 120 includes the primary winding P1 connected to the output terminal of the first power amplifier PA1, the primary winding P2 connected to the output terminal of the second power amplifier PA2, and a single secondary winding S 1 inductively coupled with the primary windings P1 and P2.

The supply voltage switch 130 may include the first switch SW1 having one terminal connected to the first supply voltage VDD_H and another terminal connected to the center tap ports 5 of the primary windings P1 and P2, respectively, and the second switch SW2 having one terminal connected to the second supply voltage VDD_L and another terminal connected to the center tap ports 5 of the primary windings P1 and P2, respectively. In this case, the first supply voltage VDD_H may be higher than the second supply voltage VDD_L.

The controller 140 may select one supply voltage from among the plurality of supply voltages VDD_H and VDD_L and control whether to activate each of the plurality of power amplifiers PA1 and PA2, thereby controlling the output power of the RF output signal RFOUT.

According to embodiments, the RF output signal RFOUT may have an output power level corresponding to a selected power mode from among a plurality of power modes, each having a corresponding output power level. FIGS. 6A to 6E illustrate five power modes corresponding to five output power levels of the RF output signal RFOUT of the transmitter 100B. The controller 140 may select one supply voltage from among the plurality of supply voltages VDD_H and VDD_L, and control whether to activate each of the plurality of power amplifiers PA1 and PA2, thereby selecting one from the plurality of power modes.

FIG. 6A illustrates the first mode in which the RF output signal RFOUT of the transmitter 100B has the highest output power level. Referring to FIG. 6A, the controller 140 may select the first mode by selecting the first supply voltage VDD_H and activating all of the plurality of power amplifiers PA1 and PA2. To this end, the controller 140 may provide the supply voltage switch 130 with a control signal for turning on the first switch SW1 and turning off the second switch SW2. Accordingly, the first supply voltage VDD_H may be selected. In addition, the controller 140 may provide a control signal for activating the first and second power amplifiers PA1 and PA2 to the activation control ports 7 of the first and second power amplifiers PA1 and PA2, respectively. Accordingly, both the first and second power amplifiers PA1 and PA2 may be activated.

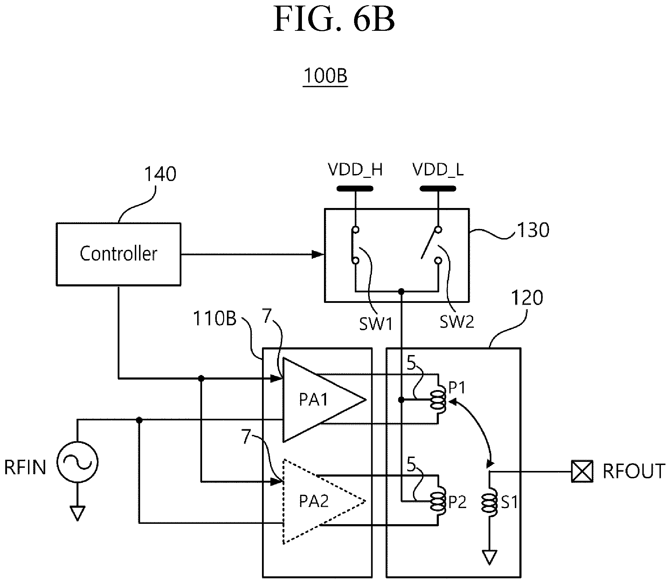

FIG. 6B illustrates the second mode in which the RF output signal RFOUT of the transmitter 100A has the second highest output power level. Referring to FIG. 6B, the controller 140 may select the first supply voltage VDD H, activate the first power amplifier PA1, and deactivate the second power amplifier PA2, thereby selecting the second mode. To this end, the controller 140 may provide a control signal for turning on the first switch SW1 and turning off the second switch SW2 to the supply voltage switch 130. Accordingly, the first supply voltage VDD_H may be selected. In addition, the controller 140 may provide a control signal for activating the first power amplifier PA1 to the activation control port 7 of the first power amplifier PA1, and provide a control signal for deactivating the second power amplifier PA2 to the activation control port 7 of the second power amplifier PA2. Accordingly, the first power amplifier PA1 may be activated and the second power amplifier PA2 may be deactivated.

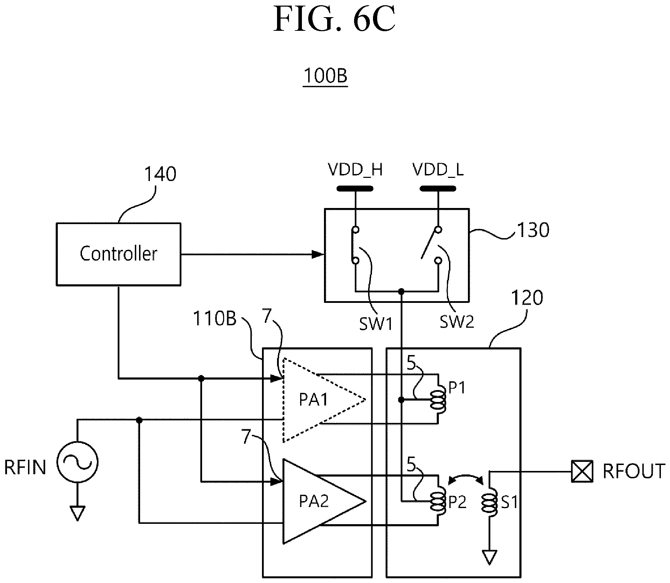

FIG. 6C illustrates a third mode in which the RF output signal RFOUT of the transmitter 100B has the third highest output power level. Referring to FIG. 6C, the controller 140 may select the first supply voltage VDD_H, deactivate the first power amplifier PA1, and activate the second power amplifier PA2, thereby selecting the third mode. To this end, the controller 140 may provide a control signal for turning on the first switch SW1 and turning off the second switch SW2 to the supply voltage switch 130. Accordingly, the first supply voltage VDD_H may be selected. In addition, the controller 140 may provide a control signal for deactivating the first power amplifier PA1 to the activation control port 7 of the first power amplifier PA1, and may provide a control signal for activating the second power amplifier PA2 to the activation control port 7 of the second power amplifier PA2. Accordingly, the first power amplifier PA1 may be deactivated and the second power amplifier PA2 may be activated.

In both the second and third modes, the first supply voltage VDD_H is selected, and the supply voltages provided to the first power amplifier PA1 and the second power amplifier PA2 are the same (or similar). However, because the first power amplifier PA1 has a higher power gain than the second power amplifier PA2, the output power level of the RF output signal RFOUT is higher in the second mode than in the third mode.

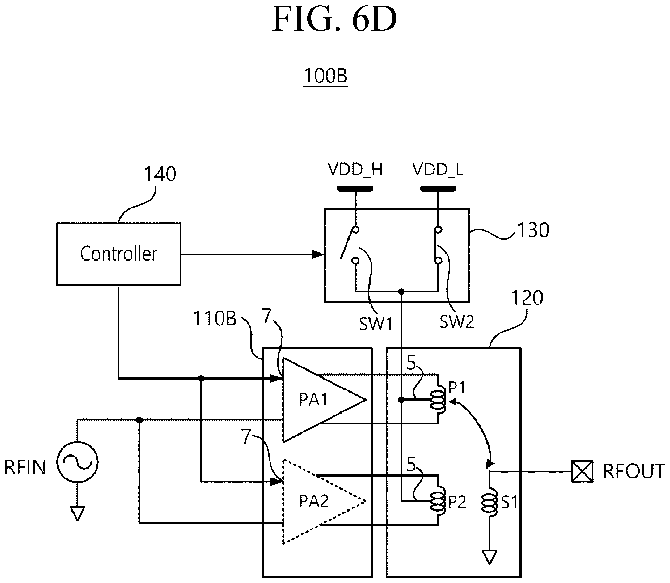

FIG. 6D illustrates a fourth mode in which the RF output signal RFOUT of the transmitter 100B has the fourth highest output power level. Referring to FIG. 6D, the controller 140 may select the second supply voltage VDD_L, activate the first power amplifier PA1, and deactivate the second power amplifier PA2, thereby selecting the fourth mode. To this end, the controller 140 may provide a control signal for turning off the first switch SW1 and turning on the second switch SW2 to the supply voltage switch 130. Accordingly, the second supply voltage VDD_L may be selected. In addition, the controller 140 may provide a control signal for activating the first power amplifier PA1 to the activation control port 7 of the first power amplifier PA1, and provide a control signal for deactivating the second power amplifier PA2 to the activation control port 7 of the second power amplifier PA2. Accordingly, the first power amplifier PA1 may be activated and the second power amplifier PA2 may be deactivated.

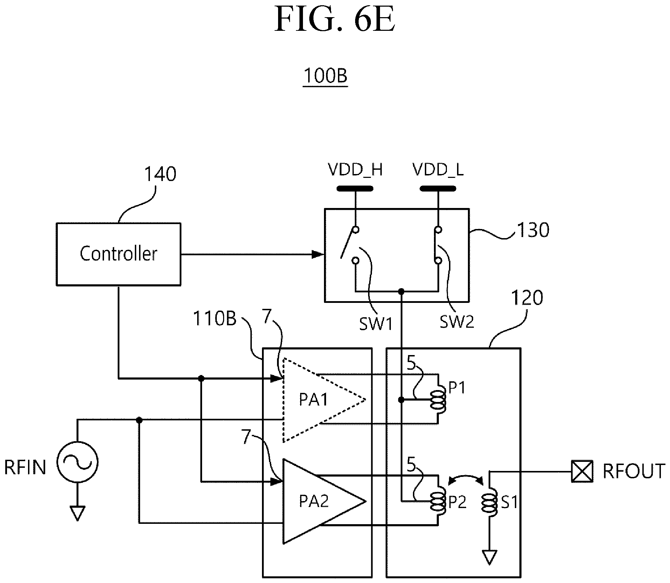

FIG. 6E illustrates a fifth mode in which the RF output signal RFOUT of the transmitter 100B has the lowest output power level. Referring to FIG. 6E, the controller 140 may select the second supply voltage VDD_L, deactivate the first power amplifier PA1, and activate the second power amplifier PA2, thereby selecting the fifth mode. To this end, the controller 140 may provide a control signal for turning off the first switch SW1 and turning on the second switch SW2 to the supply voltage switch 130. Accordingly, the second supply voltage VDD_L may be selected. In addition, the controller 140 may provide a control signal for deactivating the first power amplifier PA1 to the activation control port 7 of the first power amplifier PA1, and provide a control signal for activating the second power amplifier PA2 to the activation control port 7 of the second power amplifier PA2. Accordingly, the first power amplifier PA1 may be deactivated and the second power amplifier PA2 may be activated.

According to embodiments, the transmitter 100B may operate according to a sixth mode (not illustrated) in which the controller 140 may select the second supply voltage VDD_L, activate the first power amplifier PA1, and activate the second power amplifier PA2. To this end, the controller 140 may provide a control signal for turning off the first switch SW1 and turning on the second switch SW2 to the supply voltage switch 130. Accordingly, the second supply voltage VDD_L may be selected. In addition, the controller 140 may provide a control signal for activating the first power amplifier PA1 to the activation control port 7 of the first power amplifier PA1, and provide a control signal for activating the second power amplifier PA2 to the activation control port 7 of the second power amplifier PA2. Accordingly, both the first power amplifier PA1 and the second power amplifier PA2 may be activated.

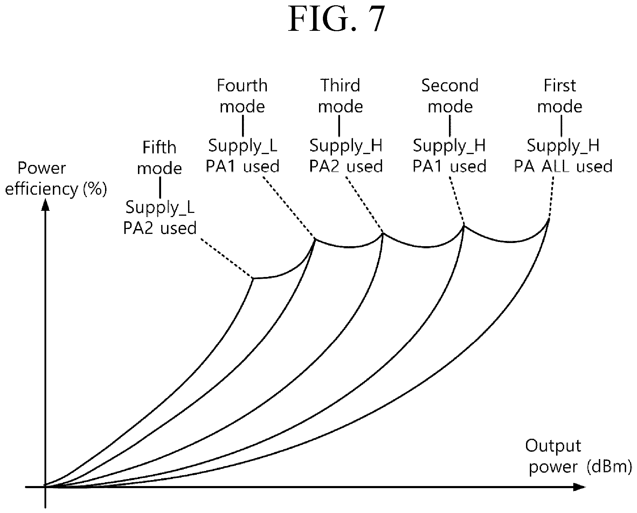

FIG. 7 is a diagram illustrating power efficiency according to the operation modes of FIGS. 6A to 6E. Referring to FIG. 7, it may be confirmed that in all five modes, higher power efficiency is maintained at a level similar to the power efficiency at maximum (or highest) output. The sixth mode, while not shown in Figure 7, higher power efficiency is also maintained for this mode at a level similar to the power efficiency at maximum (or highest) output.

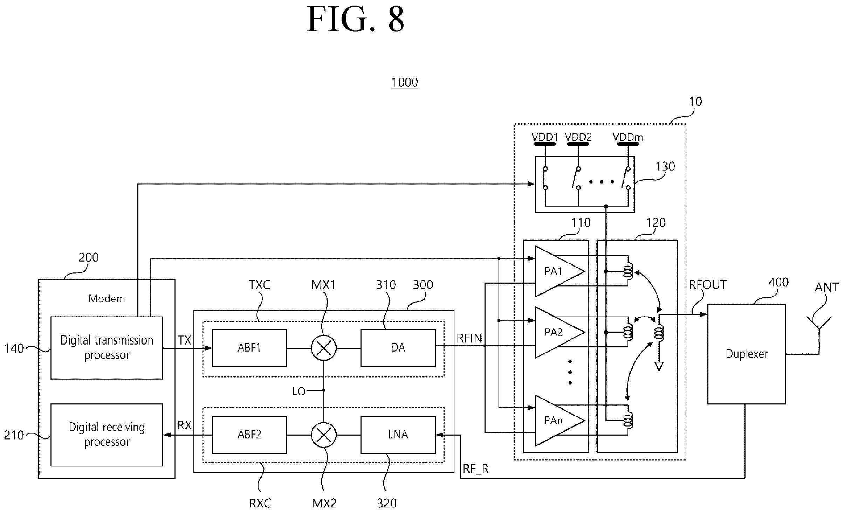

FIG. 8 is a block diagram illustrating the configuration of a wireless communication module according to embodiments of the present disclosure. Referring to FIG. 8, a wireless communication module 1000 may include the power amplification system 10, a modem 200, an Radio Frequency Integrated Circuit (RFIC) 300, a duplexer 400, and/or an antenna ANT.

The modem 200 may include a digital transmission processor 140 and/or a digital receiving processor 210. The modem 200 may process a baseband signal containing information to be transmitted through the digital transmission processor 140 according to a specified communication scheme. In addition, the modem 200 may process the received baseband signal (e.g., a different baseband signal from that transmitted through the digital transmission processor 140) through the digital receiving processor 210 according to a specified communication scheme. For example, the modem 200 may process a signal to be transmitted or a received signal according to a communication scheme such as orthogonal frequency division multiplexing (OFDM), orthogonal frequency division multiple access (OFDMA), wideband code multiple access (WCDMA), high speed packet access+ (HSPA+), or the like. In addition, the modem 200 may process a baseband signal according to various types of communication schemes such as Bluetooth, Wi-Fi, mobile communication, and the like. According to embodiments, the wireless communication module 1000 may be a Bluetooth communication module (e.g., may be configured to perform Bluetooth communication), a Wi-Fi communication module (e.g., may be configured to perform Wi-Fi communication), a mobile communication module (e.g., may be configured to perform communication in a cellular communication system), etc. According to embodiments, the wireless communication module 1000 may be included in a UE, or a base station, on which one or more applications may be executed. According to embodiments, the one or more applications may generate a first signal (e.g., in response to a user/operator input with respect to the one or more applications, in response to receipt of another signal via the wireless communication module 1000, etc.) and may provide the first signal to the modem 200 to be processed for transmission by the wireless communication module 1000. According to embodiments, the modem 200 may provide a second signal received by the wireless communication module 1000 to the one or more applications which may perform one or more further operations on the second signal. For example, the one or more applications may perform a service (e.g., for a user/operator of the UE or base station) based on the second signal, store the second signal, send a response signal to the modem 200 to be processed for transmission by the wireless communication module 1000 based on data provided in the second signal, etc.

The modem 200 may perform digital-to-analog conversion on a baseband signal by using a digital-to-analog converter provided therein, and generate a transmission signal TX, which is an analog signal. In addition, the modem 200 may receive a reception signal RX, which is an analog signal, from the RFIC 300, and may analog-to-digital convert the reception signal RX through the analog-to-digital converter provided therein, thereby extracting the baseband digital signal which is a digital signal.

In particular, the modem 200 may perform the functions of the controller 140 described above through the digital transmission processor 140.

The RFIC 300 may generate the RF input signal RFIN by performing frequency up-conversion on the transmission signal TX, or generate the reception signal RX by performing frequency down-conversion on a RF reception signal RF_R. In detail, the RFIC 300 may include a transmitting circuit TXC for frequency up-conversion, a receiving circuit RXC for frequency down-converting, and/or a local oscillator LO.

The transmitting circuit TXC may include a first analog baseband filter ABF1, a first mixer MX1, and/or a driving amplifier (DA) 310. For example, the first analog baseband filter AFB1 may include a low pass filter.

The baseband filter ABF1 may filter the transmission signal TX received from the modem 200 and provide the filtered signal to the first mixer MX1. The first mixer MX1 may perform frequency up-conversion to convert the frequency of the transmission signal TX from the baseband to the higher frequency band through the frequency signal provided by the local oscillator LO. Through frequency up-conversion, the transmission signal TX may be provided to the driving amplifier 310 as an RF signal. The driving amplifier 310 may primarily amplify the RF signal and provide it to the power amplification system 10 as an RF input signal RFIN.

The power amplification system 10 may include the plurality of power amplifiers 110, the parallel power combiner 120, and the supply voltage switch 130. The configuration and operation of the components included in the power amplification system 10 have been described in detail with reference to FIGS. 1 to 7, and redundant description will be omitted. The RF output signal RFOUT generated by the parallel power combiner 120 may be provided to the duplexer 400.

The receiving circuit RXC may include a second analog baseband filter ABF2, a second mixer MX2, and/or a low noise amplifier (LNA) 320. For example, the second analog baseband filter ABF2 may include a low pass filter.

The low-noise amplifier 320 may amplify the RF reception signal RF_R provided from the duplexer 400 and provide the amplified signal to the second mixer MX2. The second mixer MX2 may perform frequency down-conversion to convert the frequency of the signal provided from the low noise amplifier 320 from the higher frequency band to the baseband through the frequency signal provided by the local oscillator LO. The reception signal RX generated through frequency down-conversion may be provided to the second analog baseband filter ABF2, and the second analog baseband filter ABF2 may filter the reception signal RX and provide the filtered signal to the modem 200.

The duplexer 400 may be connected to the antenna ANT and is configured to separate the transmission frequency and the reception frequency. For example, the duplexer 400 may separate the RF output signal RFOUT by frequency band and provide it to the corresponding antenna ANT. In addition, the duplexer 400 may provide an external signal received through the antenna ANT to the low-noise amplifier 320 of the receiving circuit RXC of the RFIC 300. For example, the duplexer 400 may include a front end module with integrated duplexer (FEMiD).

According to embodiments, the wireless communication module 1000 may be provided with a switch structure that may separate the transmission frequency and the reception frequency instead of the duplexer 400. In addition or alternatively, the wireless communication module 1000 may be provided with a structure including the duplexer 400 and a switch to separate the transmission frequency and the reception frequency.

The antenna ANT may transmit the RF output signal RFOUT frequency-separated by the duplexer 400 to an outside (e.g., to an external device such as a base station, a mobile telephone, etc.), or provide the RF reception signal RF_R received from the outside to the duplexer 400. For example, the antenna ANT may include an array antenna, but embodiments are not limited thereto.

According to embodiments, the modem 200, the power amplification system 10, the RFIC 300, and/or the duplexer 400 may be individually implemented as ICs, chips, or modules. Alternatively, according to embodiments, the modem 200, the power amplification system 10, the RFIC 300, and/or the duplexer 400 may be mounted together on a printed circuit board (PCB), but embodiments are not limited thereto. According to embodiments, at least some of the plurality of power amplifiers 110, the parallel power combiner 120, the supply voltage switch 130, the modem 200, the RFIC 300, and/or the duplexer 400 are implemented as a single chip.

Furthermore, the wireless communication module 1000 may be included in a wireless communication system using a cellular network such as 5G, LTE, and the like, or may be included in a wireless local area network (WLAN) system or another wireless communication system. That is, the configuration of the wireless communication module 1000 shown in FIG. 8 is only one example, is not limited thereto, and may be configured in various manners depending on communication protocols or communication schemes.

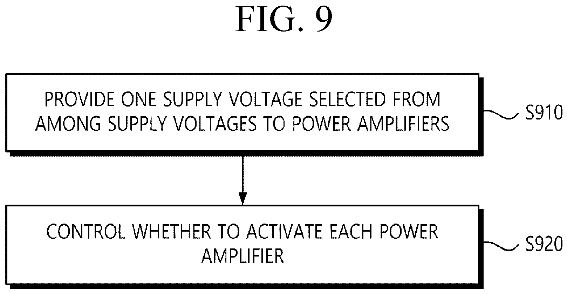

FIG. 9 is a flow chart illustrating an operating method of a transmitter according to embodiments of the present disclosure. In describing FIG. 9, the description which is given above will be omitted or simplified.

Referring to FIG. 9, in operation S910, the transmitter 100 may provide one supply voltage selected from among a plurality of supply voltages to the plurality of power amplifiers 110. For example, the controller 140 may control the supply voltage switch 130 to select one supply voltage. Accordingly, the selected one supply voltage may be provided to the plurality of power amplifiers 110.

In operation S920, the transmitter 100 may control whether to activate each of the plurality of power amplifiers 110. For example, each of the plurality of power amplifiers 110 may include an activation control port 7 for determining activation or deactivation of the corresponding power amplifier. Accordingly, the controller 140 may provide a control signal for determining whether to activate the corresponding power amplifier to each of the activation control ports 7 to control whether to activate each of the plurality of power amplifiers 110.

Meanwhile, the transmitter 100 may include the parallel power combiner 120 generating an RF output signal RFOUT through parallel combination of the outputs of the plurality of power amplifiers 110. The parallel power combiner 120 may include a plurality of primary windings respectively corresponding to the plurality of power amplifiers 110 and a single secondary winding inductively coupled with the plurality of primary windings.

According to embodiments of the present disclosure described above, the transmitter 100 or the power amplification system 10 may provide a plurality of output powers through a single output path. In addition, because the parallel power combiner 120 including a single secondary winding is used, the area and cost may be reduced compared to general technology. In addition, because output powers are implemented by adjusting the supply voltage and whether to activate the power amplifier, it is possible to achieve optimized (or reduced) power consumption.

Conventional devices and methods for transmitting a wireless signal use different output paths respectively corresponding to different transmission powers at which the wireless signal is to be transmitted. Each of the different output paths includes corresponding power amplifiers and corresponding passive elements. For example, each of the different output paths includes a primary winding inductively coupled to a corresponding secondary winding. Accordingly, a transmitter of the conventional devices and methods occupies an excessive amount of physical area in a communication chip. Also, such a transmitter includes an excessive amount of elements (e.g., power amplifiers, passive elements, secondary windings, etc.) that results in higher manufacturing costs. Additionally, the transmitter of the conventional devices and methods may result in excessive power consumption and/or insufficient power efficiency when used to transmit a wireless signal at lower transmission powers.

However, according to embodiments, improved devices and methods are provided for transmitting a wireless signal. For example, the improved devices and methods provide only one output path through which wireless signals of varying transmission powers may be transmitted. The output path may include only one secondary winding inductively coupled to one or more primary windings. Accordingly, the improved devices and methods overcome the deficiencies of the conventional devices and methods to provide a transmitter that occupies are reduced amount of physical area in a communication chip and/or decreases manufacturing costs. Additionally, such a transmitter may result in reduced power consumption and/or increased power efficiency when used to transmit a wireless signal at lower transmission powers.

According to embodiments, operations described herein as being performed by the transmitter 100, the controller 140, each of the plurality of power amplifiers 110, the power amplification system 10, the transmitter 100A, each of the plurality of power amplifiers 110A, the transmitter 100B, each of the plurality of power amplifiers 110B, the wireless communication module 1000, the power amplification system 10, the modem 200, the RFIC 300, the duplexer 400, the digital transmission processor 140, the digital receiving processor 210, the transmitting circuit TXC, the receiving circuit RXC, the local oscillator LO, the first analog baseband filter ABF1, the first mixer MX1, the DA 310, the second analog baseband filter ABF2, the second mixer MX2 and/or the LNA 320 may be performed by processing circuitry. The term 'processing circuitry,' as used in the present disclosure, may refer to, for example, hardware including logic circuits; a hardware/software combination such as a processor executing software; or a combination thereof. For example, the processing circuitry more specifically may include, but is not limited to, a central processing unit (CPU), an arithmetic logic unit (ALU), a digital signal processor, a microcomputer, a field programmable gate array (FPGA), a System-on-Chip (SoC), a programmable logic unit, a microprocessor, application-specific integrated circuit (ASIC), etc.

The various operations of methods described above may be performed by any suitable device capable of performing the operations, such as the processing circuitry discussed above. For example, as discussed above, the operations of methods described above may be performed by various hardware and/or software implemented in some form of hardware (e.g., processor, ASIC, etc.).

The software may comprise an ordered listing of executable instructions for implementing logical functions, and may be embodied in any "processor-readable medium" for use by or in connection with an instruction execution system, apparatus, or device, such as a single or multiple-core processor or processor-containing system.

The blocks or operations of a method or algorithm and functions described in connection with embodiments disclosed herein may be embodied directly in hardware, in a software module executed by a processor, or in a combination of the two. If implemented in software, the functions may be stored on or transmitted over as one or more instructions or code on a tangible, non-transitory computer-readable medium. A software module may reside in Random Access Memory (RAM), flash memory, Read Only Memory (ROM), Electrically Programmable ROM (EPROM), Electrically Erasable Programmable ROM (EEPROM), registers, hard disk, a removable disk, a CD ROM, or any other form of storage medium known in the art.

Although terms of "first" or "second" may be used to explain various components, the components are not limited to the terms. These terms should be used only to distinguish one component from another component. For example, a "first" component may be referred to as a "second" component, or similarly, and the "second" component may be referred to as the "first" component. Expressions such as "at least one of" when preceding a list of elements, modify the entire list of elements and do not modify the individual elements of the list. For example, the expression, "at least one of a, b, and c," should be understood as including only a, only b, only c, both a and b, both a and c, both b and c, all of a, b, and c, or any variations of the aforementioned examples. As used herein the term "and/or" includes any and all combinations of one or more of the associated listed items.

Specific examples have been described above. The present disclosure may include not only the above-described examples, but also simple design changes or easily changeable examples. In addition, the present disclosure may include techniques that may easily modify and implement the examples. Therefore, the scope of the present disclosure should not be limited to the above-described examples, but should be defined by the claims described below as well as the claims and equivalents.

## Claims

1. A transmitter comprising:
a plurality of power amplifiers, each of the plurality of power amplifiers being configured to receive an RF input signal;
a parallel power combiner configured to combine outputs of the plurality of power amplifiers to generate an RF output signal;
a supply voltage switch configured to provide one supply voltage to the plurality of power amplifiers, the one supply voltage being selected from among a plurality of supply voltages of different voltage levels; and
a controller configured to control an output power of the RF output signal by
selecting the one supply voltage from among the plurality of supply voltages, and
controlling whether to activate each of the plurality of power amplifiers.

2. The transmitter of claim 1, wherein the parallel power combiner includes:
a plurality of primary windings respectively connected to output terminals of the plurality of power amplifiers; and
a single secondary winding inductively coupled with the plurality of primary windings.

3. The transmitter of claim 2, wherein the single secondary winding includes one end connected to a ground and an opposite end configured to output the RF output signal.

4. The transmitter of claim 2 or claim 3, wherein
each of the plurality of primary windings includes a center tap port; and
the one supply voltage is provided to each of the plurality of power amplifiers through the center tap port of each of the plurality of primary windings.

5. The transmitter of claim 1, wherein
the supply voltage switch includes a plurality of switches respectively corresponding to the plurality of supply voltages;
the parallel power combiner includes a plurality of primary windings respectively connected to output terminals of the plurality of power amplifiers; and
each of the plurality of switches has a first end and a second end, the first end being connected to a corresponding supply voltage among the plurality of supply voltages, and the second end being connected to center tap ports of the plurality of primary windings.

6. The transmitter of claim 5, wherein the controller is configured to select the one supply voltage by providing a control signal to the supply voltage switch, the control signal causing the supply voltage switch to:
turn on a first switch corresponding to the one supply voltage among the plurality of switches; and
turn off a second switch corresponding to a supply voltage different from the one supply voltage, the second switch being among the plurality of switches.

7. The transmitter of any preceding claim, wherein each of the plurality of power amplifiers is configured to:
output an amplified signal corresponding to the RF input signal in an activated state; and
not output the amplified signal corresponding to the RF input signal in a deactivated state.

8. The transmitter of claim 7, wherein
each respective power amplifier among the plurality of power amplifiers includes a corresponding activation control port for determining activation or deactivation of the respective power amplifier; and
the controller is configured to control whether to activate each respective power amplifier among the plurality of power amplifiers by providing a corresponding control signal to the corresponding activation control port.

9. The transmitter of any preceding claim, wherein each of the plurality of power amplifiers is a differential amplifier.

10. The transmitter of any preceding claim, wherein each of the plurality of power amplifiers has a same power gain.

11. The transmitter of any one of claims 1 - 9, wherein the plurality of power amplifiers include a first power amplifier and a second power amplifier having different power gains.

12. The transmitter of any preceding claim, wherein the transmitter is configured such that
the RF output signal has an output power level corresponding to a power mode selected from among a plurality of power modes, each of the plurality of power modes having a corresponding output power level; and
the controller is configured to select one power mode from among the plurality of power modes by
selecting one supply voltage from among the plurality of supply voltages, and
controlling whether to activate each of the plurality of power amplifiers.

13. The transmitter of any preceding claim, wherein the transmitter is configured such that the output power of the RF output signal increases as a higher supply voltage is selected as the one supply voltage from among the plurality of supply voltages.

14. The transmitter of any preceding claim, wherein the transmitter is configured such that the output power of the RF output signal increases as a number of activated power amplifiers among the plurality of power amplifiers increases.

15. The transmitter of any preceding claim, wherein an impedance viewed from an output terminal of an activated power amplifier toward the parallel power combiner increases as a number of deactivated power amplifiers among the plurality of power amplifiers increases, the activated power amplifier being among the plurality of power amplifiers.
